# EUROPEAN PATENT APPLICATION

(11) **EP 2 055 394 A2**
(43) Date of publication of application: **06.05.2009**
(21) Application number: 08165941.9
(22) Date of filing: 06.10.2008
(51) Int. Cl.: B05C 5/02, B05C 11/10

(54) **Fluid dispensers and methods for dispensing viscous fluids with improved edge definition**

(30) Priority: 31.10.2007 US 931397
(71) Applicant: NORDSON CORPORATION, Westlake, OH 44145 (US)
(72) Inventor: Hassler, William L. Jr., Carlsbad, CA 92008 (US); Tedrow, Jon D., San Diego, CA 92117 (US)
(74) Representative: Andres, Mark

(57) **Abstract**

Fluid dispensers (10,12,14) and methods for dispensing viscous fluids with improved edge definition. Pressurized fluid is periodically supplied in pulses to nozzles (80) in a nozzle plate (18) of a dispensing head as the dispensing head is moved by a multi-axis stage relative to a stationary substrate. Droplets are discharged from the nozzles (80) and impact on the substrate. The droplets coalesce together to define the coating. The discharge from one or more groups of nozzles (80) can be temporarily suspended to avoid coating a component or area on the substrate (120) while adjacent areas continue to receive droplets of the fluid.

## Description

### Field of the Invention

The present invention relates generally to fluid dispensers for dispensing viscous fluids and, in particular, to fluid dispensers configured to dispense viscous fluids onto substrates with improved precision and edge definition.

### Background of the Invention

Non-contact fluid dispensers are often used to apply minute amounts of viscous materials onto substrates. For example, non-contact fluid dispensers are used to apply various viscous materials in small amounts onto electronic substrates like printed circuit boards (PCBs) or semiconductor carriers or wafers. Numerous applications exist that dispense a viscous material from a non-contact dispenser onto a substrate. In semiconductor package assembly, applications exist for underfilling, solder ball reinforcement in ball grid arrays, dam and fill operations, chip encapsulation, underfilling chip scale packages, cavity fill dispensing, die attach dispensing, lid seal dispensing, no flow underfilling, flux jetting, and dispensing thermal compounds, among other uses. For surface-mount technology PCB production, surface mount adhesives, solder paste, conductive adhesives, and solder mask materials may be dispensed from non-contact dispensers, as well as selective flux jetting. Conformal coatings may also be applied selectively using a non-contact dispenser. Applications also exist in the disk drive industry, in life sciences applications for medical electronics, and in general industrial applications for bonding, sealing, forming gaskets, painting, and lubrication.

Conventional automated fluid dispensing systems include a non-contact fluid dispenser mounted on a robot, which has an articulated arm that moves the dispenser relative to the recipient substrate. The system is equipped to precisely dispense amounts of viscous material reproducibly from the fluid dispenser at targeted locations on each substrate. The flow and discharge of fluid in conventional fluid dispensers is regulated by a valve assembly featuring a valve seat in a fluid passage and a valve element movable to selectively contact the valve seat to provide distinct opened and closed conditions that permit and interrupt, respectively, the flow of material to a discharge orifice. Hence, cyclic movement between the opened and closed positions causes intermittent flow discontinuities necessary to generate a pattern of fluid on a surface of the product or product packaging.

Conventional automated fluid dispensers rely on various techniques for applying a viscous fluid over a large surface area on electronic substrates like PCBs. To avoid contact with object projecting from the surface of the substrate, the fluid dispenser is suspended above the substrate and moved relative to the substrate while dispensing fluid. One approach involves masking selected regions on the surface and indiscriminately spraying the fluid onto the entire surface. Another approach is to use an atomizing spray that has a well-defined fan width. However, this approach is limited to low viscosity fluids and deposits on the substrate with a film thickness that varies with position between the edges of the fan spray. Other approaches are to use a nozzle that is capable of dispensing fluid in a pattern (e.g., a swirl pattern) with a well-defined width or to use a slot nozzle. However, edge definition may be poor for atomizing sprays or patterned fluid application.

It would therefore be desirable to provide a fluid dispenser that can apply a viscous fluid over large surface areas of a substrate with improved precision in edge definition and accurate build thickness.

### Summary of the Invention

In accordance with one embodiment of the invention, an apparatus is provided for applying a pressurized fluid on a stationary substrate to form a coating. The apparatus comprises at least one fluid dispenser and a multi-axis stage mechanically coupled with the fluid dispenser(s). Each fluid dispenser includes an actuator, a fluid chamber containing the pressurized fluid, a valve element coupled with the actuator, and a fluid passageway connected with the fluid chamber at a valve seat. The actuator of each fluid dispenser is configured to move the valve element relative to the valve seat between an open position to permit the pressurized fluid to flow from the fluid chamber into the fluid passageway and a closed position in which the valve element contacts the valve seat to establish a fluid seal between the fluid chamber and the fluid passageway. The multi-axis stage is configured to move the fluid dispenser(s) relative to the stationary substrate.

The apparatus further comprises at least one nozzle plate mechanically coupled with the at least one fluid dispenser. Each nozzle plate includes a fluid cavity coupled with the fluid passageway and a plurality of nozzles coupled with the fluid chamber. When the valve element of each fluid dispenser is in the open position, the corresponding fluid cavity is configured to receive the pressurized fluid for discharge from the plurality of nozzles.

The fluid dispenser(s) and nozzle plate are capable of dispensing a variety of different types of fluids and permits tight control over the film build or thickness on the substrate. The fluid dispenser(s) and nozzle plate are capable of accurate edge definition because, at least in part, of the rectilinear or trapezoidal pattern dispensed from the nozzle array that, as the fluid dispenser(s) are moved relative to the substrate, overlap and define a strip of fluid deposited on the substrate. As a consequence, the fluid dispenser(s) can dispense fluid onto more densely packed objects on a substrate.

In accordance with another embodiment of the invention, a method is provided for dispensing a pressurized fluid onto a stationary substrate to define a coating. The method comprises discharging a first plurality of droplets of the pressurized fluid from a first plurality of nozzles onto the stationary substrate and discharging a second plurality of droplets of the pressurized fluid from a second plurality of nozzles onto the stationary substrate. The method further comprises moving the first plurality of nozzles and the second plurality of nozzles relative to the stationary substrate while discharging the first plurality of droplets and the second plurality of droplets.

The construction of the nozzle plate, in conjunction with high frequency operation and low duty cycles, causes the fluid ejected from the nozzles to travel in a direction that is approximately parallel to the centerline of the discharge passageway in each nozzle. The fluid cavity has dimensions optimized to minimize the dead volume and enable high frequency operation.

### Brief Description of the Drawings

The accompanying drawings, which are incorporated in and constitute a part of this specification, illustrate embodiments of the invention and, together with a general description of the invention given above, and the detailed description of the embodiments given below, serve to explain the principles of the invention.

Fig. 1 is a perspective view of a plurality of dispensers having a juxtaposed spatial relationship in accordance with an embodiment of the invention.

Fig. 2 is a cross-sectional view taken generally along line 2-2 in Fig. 1 with the dispenser depicted in a closed condition.

Fig. 3 is a cross-sectional view taken generally along line 3-3 in Fig. 1 with the dispensers depicted in a closed condition.

Fig. 4 is a perspective view of a portion of the nozzle plate used with the dispensers of Fig. 1 in which the nozzle plate is depicted removed from the dispensers.

Fig. 5 is a bottom view of the nozzle plate of Fig. 4.

Fig. 6 is an enlarged view of a portion of Fig. 2.

Fig. 7 is a schematic representation of a fluid dispensing system that includes the fluid dispensers of Figs. 1-6 in accordance with an embodiment of the invention.

Fig. 8 is a partially broken-away side view of a dispenser and nozzle plate in accordance with an alternative embodiment.

Fig. 9 is a partially broken-away end view of the dispenser and nozzle plate of Fig. 8.

Fig. 10 is a perspective view of a nozzle plate used with the dispenser of Fig. 8 in which the nozzle plate is depicted removed from the dispenser.

Fig. 11 is a perspective view of a portion of a dispenser and a nozzle plate in accordance with another alternative embodiment that includes an extension that spaces the nozzle plate from the dispenser.

Fig. 12 is a cross-sectional view taken generally along line 12-12 in Fig. 11.

### Detailed Description of the Preferred Embodiments

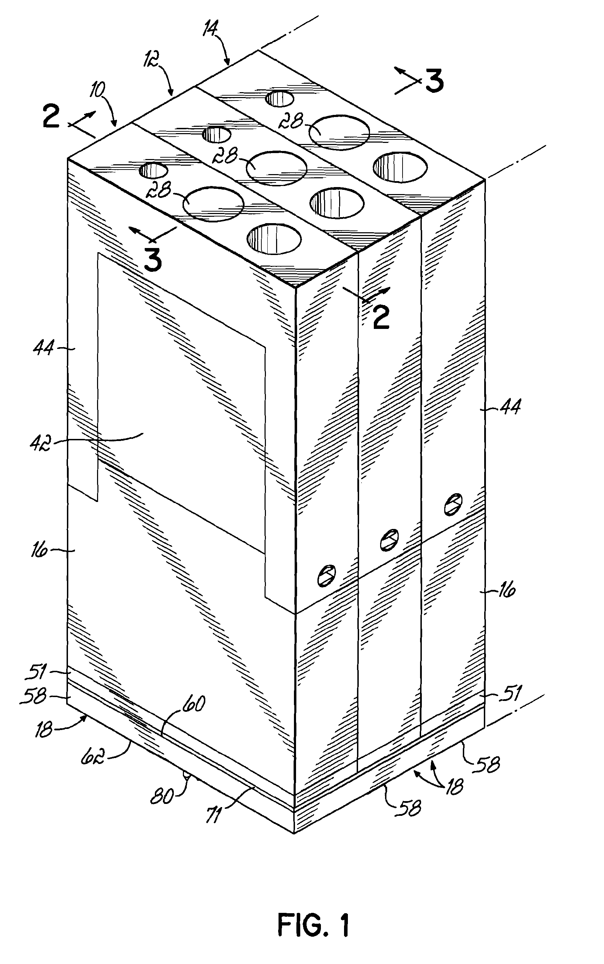

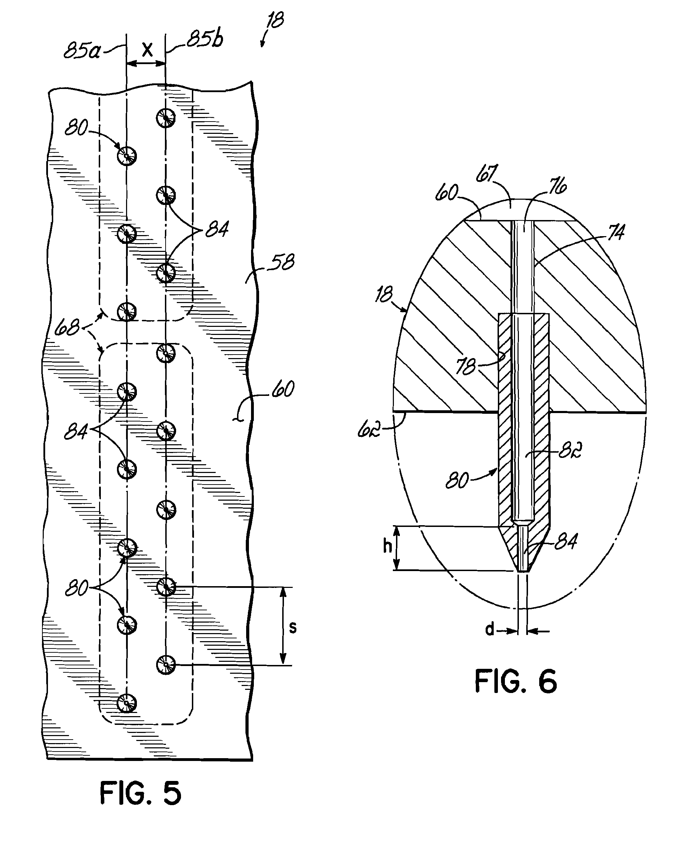

With reference to Figs. 1-3, a plurality of fluid guns or dispensers 10, 12, 14 are configured as a single dispensing head and may be used in a fluid dispensing machine or system 110 (Fig. 6) for intermittently dispensing amounts of a viscous fluid onto a stationary substrate 120 (Fig. 6). Fluid dispensers 10, 12, 14 may be used to dispense ambient temperature viscous fluids, including cold adhesives or glues, and heated viscous liquids, such as conformal coatings, fluxes, and hot melt adhesives. The fluid dispenser 10, 12, 14 are operated in a known manner for intermittently dispensing viscous fluid in discrete volumes on the stationary substrate 120. As shown in Fig. 1, the fluid dispensers 10, 12, 14 are positioned side-by-side in a stack or juxtaposed to define the dispensing head of the fluid dispensing system 110 and are associated with a nozzle plate 18. The compactness of the fluid dispensers 10, 12, 14 and, in particular, the narrowness of the fluid dispensers 10, 12, 14 permits minimization of the spacing between adjacent fluid dispensers 10, 12, 14 and denser packing of juxtaposed fluid dispensers 10, 12, 14.

Each of the fluid dispensers 10, 12, 14 has a substantially identical construction. Consequently, the following description of fluid dispenser 10 is understood to apply equally to fluid dispensers 12 and 14. In alternative embodiments, additional fluid dispensers (not shown) can be ganged with fluid dispensers 10, 12, 14. The total number of fluid dispensers will vary contingent upon the dispensing application. The individual fluid dispensers 10, 12, 14 have a narrow width (e.g., about 0.33 inch) so that multiple units can have a juxtaposed arrangement that spans the entire width of the substrate 120 or a portion of the width of the substrate 120.

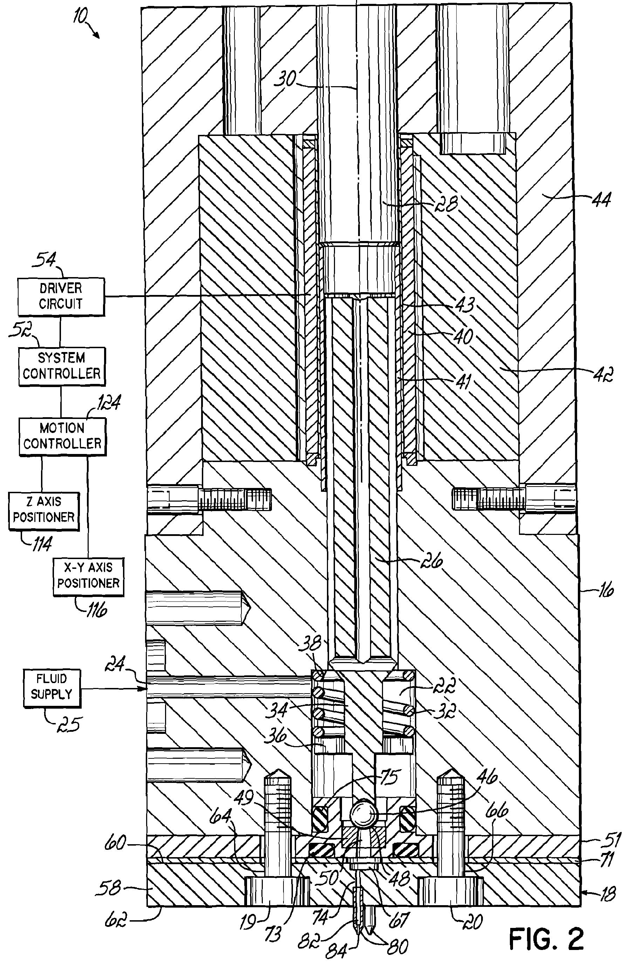

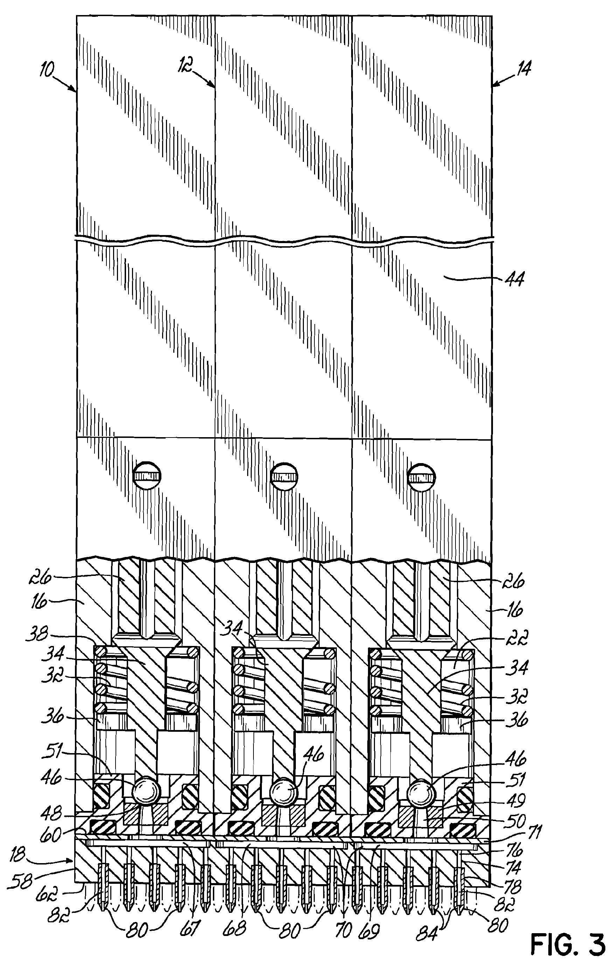

With reference to Figs. 2 and 3, fluid dispenser 10 includes a module body 16, a fluid chamber 22, and a fluid inlet 24 configured to couple the fluid chamber 22 with a heated manifold communicating with a fluid supply 25. Fluid supplied under pressure from the fluid supply 25 is admitted through the fluid inlet 24 into the fluid chamber 22. Fluid dispenser 10 is equipped with an electromagnetic actuator that includes a movable armature 26, a static pole piece 28 coaxially aligned with the armature 26 along a longitudinal axis 30, and a return spring 32 inside the fluid chamber 22 that biases the armature 26 in a direction away from the pole piece 28. Extending axially from the armature 26 is an integral valve stem 34. A flange 36 projects radially outward from the valve stem 34. The return spring 32 is captured in a compressed state between a shoulder 38 defined inside the fluid chamber 22 and the flange 36.

A solenoid coil 40 is wound circumferentially about an armature tube 41 with a bore in which the armature 26 and pole piece 28 are disposed. The windings of the solenoid coil 40 are electrically coupled with a driver circuit 54 that energizes and deenergizes the solenoid coil 40 in a controlled manner to operate the fluid dispenser 10. A heat sink 42, which is disposed between a U-shaped flux return 44 and the solenoid coil 40, extracts heat generated by the energized solenoid coil 40. The heat sinks 42 of the different fluid dispensers 10, 12, 14 are contacting so that heat can be transferred between the heat sinks 42 and to another body (not shown) with a relatively large heat capacity for extracting heat from the fluid dispensers 10, 12, 14 and, thereby, cooling the fluid dispensers 10, 12, 14.

In the representative embodiment, the solenoid coil 40 is electrically isolated from the armature tube 41, for example, by disposing an electrical isolation barrier, such as a dielectric layer 43, between the windings of the solenoid coil 40 and the outer surface of the armature tube 41. The dielectric layer 43 may be defined by a polyimide layer. One suitable polyimide layer is a Kapton^{®} polyimide film, which is commercially available from DuPont^{™}. In another embodiment, the solenoid coil 40 or the outer surface of the armature tube 41 may be coated with a thin dielectric coating. In yet another embodiment, the armature tube 41 may be constructed from anodized aluminum in which the anodized outer surface of the armature tube 41 operates as the dielectric serving as the electrical isolation barrier between the armature tube 41 and the solenoid coil 40.

The dielectric layer 43 eliminates the need for the use of a bobbin in conjunction with solenoid coil 40, which in turn may permit the use of a larger gauge wire for the windings of solenoid coil 40 as more packing space is available as a result of the omission of the bobbin. The large gauge wire reduces the coil resistance and increases the efficiency of the electromagnetic actuator by reducing heat generation in the energized solenoid coil 40. This may be beneficial in connection with high frequency operation of the solenoid coil 40.

A valve element 46, which is disposed at a free end of the valve stem 34, moves concurrently with the movement of the armature 26 and valve stem 34 as the windings of the solenoid coil 40 are energized and de-energized by the driver circuit 54. The valve element 46, illustrated as having a spherical or hemispherical shape in the representative embodiment, is configured to engage a valve seat 48 at an entrance to a discharge passageway 50. The valve seat 48 is carried on a valve seat member 49 secured between the module body 16 and the nozzle plate 18 by a mounting plate 51.

Electrical current flowing through the windings of the solenoid coil 40, when solenoid coil 40 is energized with a pulse of power from the driver circuit 54, produces an electromagnetic field. The field lines of the electromagnetic field are confined to the armature 26 and pole piece 28, as well as the module body 16 and flux return 44. The field strength scales with the magnitude of the current flowing through the windings of the solenoid coil 40. When the windings of the solenoid coil 40 are energized with a sufficient current flowing in an appropriate direction, the electromagnetic field produces an attractive force sufficient to overcome the biasing force applied by the return spring 32 and to move the movable armature 26 toward the static pole piece 28. The valve stem 34 moves along with the armature 26 to an opened position in which the valve element 46 is separated from the valve seat 48. In the opened position, fluid is able to flow under pressure from the fluid chamber 22 into discharge passageway 50 leading to nozzle plate 18.

Viscous fluid discharged from the fluid chamber 22 is continuously replenished by a fresh supply of fluid flowing into the fluid chamber 22 from the fluid supply 25 by way of the fluid inlet 24. The viscous fluid introduced from fluid supply 25 through fluid inlet 24 also pressurizes the fluid chamber 22, which promotes the flow of fluid from the fluid chamber 22 into the discharge passageway 50. Fluid supply 25 may be a fluid manifold that is heated with one or more conventional heaters, such as cartridge-style resistance heaters, and that is equipped with one or more conventional temperature sensors, such as a resistance temperature detector (RTD), a thermistor, or a thermocouple, providing a feedback signal for use by a temperature controller in regulating the power supplied to the heater(s).

While the fluid dispenser 10 is dispensing fluid, the position of the armature 26 relative to the pole piece 28 is maintained by continuously supplying a holding current to the solenoid coil 40. If the current to the solenoid coil 40 is constant, the electromagnetic field is likewise constant and not time varying. The constant electromagnetic field maintains an attractive force sufficient to resist the biasing of return spring 32 that is acting in a direction to return the armature 26 to contact the valve element 46 with the valve seat 48.

When the current delivered from the driver circuit 54 to the windings of the solenoid coil 40 is either removed or reduced, the return spring 32 applies an axial force to the armature 26 that moves the valve stem 34 toward the valve seat 48. When the valve stem 34 is moved to a fully closed position by the action of the return spring 32, the valve element 46 contacts the valve seat 48, as shown in Fig. 2. The flow of fluid from the fluid chamber 22 into the discharge passageway 50 is discontinued until a dispensing sequence is initiated. In this closed condition of the fluid dispenser 10, the fluid filling the fluid chamber 22 is static and pressurized.

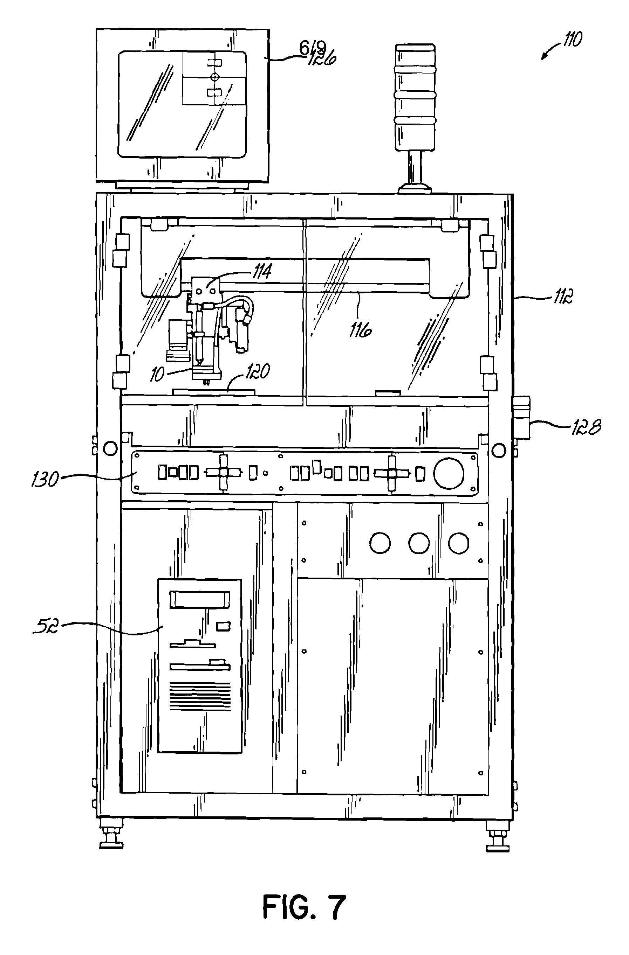

A system controller 52 provides the overall control for the fluid dispensers 10, 12, 14, as well as the fluid dispensing system 110 (Fig. 7) containing the fluid dispensers 10, 12, 14, that coordinates the movements and actuations. The system controller 52 may be a programmable logic controller (PLC), a digital signal processor (DSP), or another microprocessor-based controller with a central processing unit (CPU) capable of executing software stored in a memory and carrying out the functions described herein, as will be understood by those of ordinary skill in the art.

A human machine interface (HMI) device 126 (FIG. 7) is operatively connected to the system controller 52 in a known manner. The HMI device 126 may include output devices, such as alphanumeric displays, a touch screen, and other visual indicators, and input devices and controls, such as an alphanumeric keyboard, a pointing device, keypads, pushbuttons, control knobs, etc., capable of accepting commands or input from the operator and transmitting the entered input to the central processing unit of the system controller 52. The system controller 52 may also be connected with a control panel 130 (FIG. 7), which may include push buttons for manual initiation of certain functions, for example, during set-up, calibration, and fluid material loading.

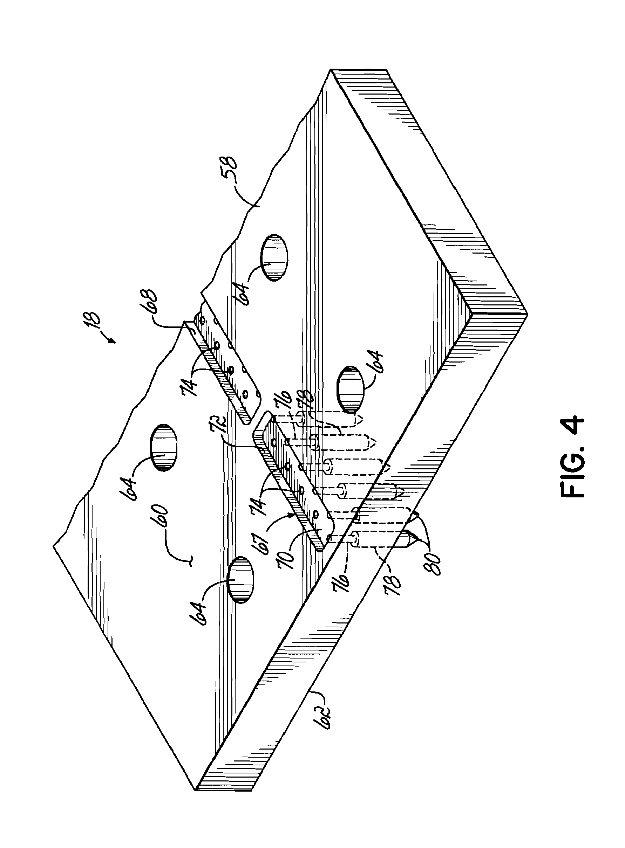

With reference to Figs. 2-6, the nozzle plate 18 coupled with the dispensers 10, 12, 14 includes a body 58 having an upstream surface 60 that faces toward the module bodies 16 and a downstream surface 62 that faces toward the product onto which the fluid is dispensed from fluid dispenser 10. Bolt holes, of which bolt holes 64 are representative, extend between the upstream and downstream surfaces 60, 62. Fasteners, of which fasteners 19, 20 (FIG. 2) are representative, project through the bolt holes 64 and the heads of the fasteners 19, 20 are received in countersunk regions of the bolt holes 64 such that the heads do not protrude beyond the plane of the downstream surface 62. Mounting plate 51 also includes openings registered with the bolt holes 64 and the threaded openings in the module body 16 of each of the dispensers 10, 12, 14 that receive the tips of the fasteners 19, 20.

Recessed into the upstream surface 60 of the body 58 are nozzle chambers or plenums having the form of cavities 67, 68, 69. Cavity 67 is coupled in fluid communication with the outlet from the discharge passageway 50 of fluid dispenser 10. Similarly, cavity 68 is coupled in fluid communication with the outlet from the discharge passageway 50 of fluid dispenser 12 and cavity 69 is coupled in fluid communication with the outlet from the discharge passageway 50 of fluid dispenser 14. A shim 71 is captured between the mounting plates 51 of the dispensers 10, 12, 14 and the upstream surface 60 of nozzle plate 18. The shim 71, which may be constructed from a stainless steel, includes openings registered with the discharge outlet 50 of the different fluid dispensers 10, 12, 14. In addition, a sealing member 73, such as an o-ring, is disposed in an annular cavity circumscribing the discharge outlet 50 from each of the fluid dispensers 10, 12, 14 and is compressed between the shim 71 and the corresponding module body 16. Another sealing member 75, such as an o-ring, is located in a groove in an outer diameter of each mounting plate 51 and is compressed between each mounting plate 51 and the module body 16 of the corresponding one of the fluid dispensers 10, 12, 14.

The cavities 67, 68, 69 are flat, thin and generally rectangular and have a substantially identical construction. Consequently, the following description of cavity 67 in the body 58 of nozzle plate 18 is understood to apply equally to cavities 68 and 69. Cavity 67 includes a floor surface 70 and a sidewall 72 that extends between the floor surface 70 and the upstream surface 60. The outlet from the discharge passageway 50 is positioned to intersect the cavity 67 at, or near, the geometrical center of cavity 67 for balanced fluid distribution to the different channels 74. Channels 74 extend through the thickness of the nozzle plate 18 and intersect the downstream surface 62. Each channel 74 has a first region 76 near the floor surface 70 and a second region 78 of larger diameter than the first region 76. The first region 76 of each channel 74 is bounded by a sidewall consisting of the material of the nozzle plate 18. The second region 78 of each channel 74 intersects the downstream surface 62 of the body 58. A filter screen (not shown) may be supplied in each of the cavities 67, 68, 69 above the channel 74 to remove particulate matter from the dispensed fluid before entering the cavities 67, 68, 69 and prevent clogging. Additional filters may be installed at other locations for removing particulates from the fluid.

Generally, the volume of the cavity 67 is minimized to minimize the dead volume for the pressurized fluid in the nozzle plate 18 and to ensure that the pressurization of the cavity 67 occurs over a short duration. For example, the cavity 67 may have a depth of about 0.5 mm (about 0.01969 inch), a length of about 1.8 mm (about 0.07087 inch), and a width of about 7 mm (about 0.2756 inch) so that the volume is about 6.3 mm³. However, the invention is not so numerically limited. Optimization of the volume of cavity 67 may promote operation of the dispenser 10 at a relatively high frequency, which may be considered to be a frequency significantly greater than about 30 Hz.

The nozzle plate 18 further includes a plurality of nozzles 80 that receive fluid from the cavity 67. One of the nozzles 80 is disposed in the second region 78 of each of the channels 74. Each of the nozzles 80 includes a first passageway 82 characterized by a diameter approximately equal to the diameter of the first region 76 of the corresponding channel 74 and a narrower second passageway 84 from which fluid is discharged. The first passageway 82 is disposed between the first region 76 of each channel 74 and the second passageway 84.

The nozzles 80, which are arranged in an array of staggered rows or lines 85a, 85b to promote close packing, project beyond the downstream surface 62 of the nozzle plate 18 and toward the substrate 120. The nozzles 80 are arranged with approximately equal spacing across the width of the nozzle plate 18. In one embodiment, adjacent nozzles 80 in line 85a and adjacent nozzles 80 in line 85b may be separated by a spacing, s, of about 1.528 mm (about 0.06016 inch) and the spacing, x, in a direction perpendicular between the two lines 85a, 85b of nozzles 80 may be about 0.764 mm (about 0.03008 inch).

The nozzles 80 may comprise sapphire nozzles, which are preferably sized with an outer diameter somewhat smaller than the inner diameter of the second region 78 of the respective channel 74, that are adhesively bonded into the channels 74. In an alternative embodiment, the nozzles 80 may be formed from titanium or a titanium alloy, such as a Ti-6A1-4V alloy, and adhesively bonded inside the second region 78 of the respective channel 74. One technique for precision forming such nozzles 80 utilizes a Swiss screw machine to turn the nozzles 80, although the invention is not so limited.

As best shown in Fig. 6, the second passageway 84 in each of the nozzles 80 may be shaped as a right circular cylinder characterized by a height or length, h, and an inner diameter, d. In one embodiment, the ratio of the length, h, to the inner diameter, d, is at least 3 to 1. In another embodiment, the ratio of the length, h, to the inner diameter, d, is about 6 to 1. The selection of a ratio in one of these ranges may operate to cause the ejected fluid streams to depart the second passageway 84 in a relatively straight path, which may be important when the nozzles 80 are hovering at a relatively large height above the substrate 120.

Typically, the inner diameter, d, of the second passageway 84 in each nozzle 80 is about 6 mils or less. In one specific embodiment, the inner diameter, d, of the second passageway 84 may be about 5 mils. In another specific embodiment, the inner diameter, d, of the second passageway 84 may be about 4 mils. In yet another specific embodiment, the inner diameter, d, of the second passageway 84 may be about 1 mil, which may permit the application of material characterized by a relatively thin film build on substrate 120 (FIG. 6) because of the concomitant small size of the ejected droplets of fluid.

During a dispensing event, the system controller 52 causes the driver circuit 54 to energize the windings of the solenoid coil 40 of fluid dispenser 10 to move the valve element 46 relative to the valve seat 48 (i.e., to move the armature 26 relative to the pole piece 28) and introduce a fresh amount of fluid under pressure into the cavity 67. When the valve element 46 is lifted from the valve seat 48, the fresh amount of pressurized fluid flows through the discharge passageway 50 into cavity 67. This incoming amount of pressurized fluid displaces the volume of fluid resident in the cavity 67 into the channels 74. When the valve element 46 contacts the valve seat 48, the fluid resident in the cavity 67 is no longer pressurized and no flow occurs from the cavity 68 into the channels 74. Fluid is concurrently discharged from the second passageway 84 of all of the nozzles 80 when the system controller 52 instructs the fluid dispenser 10 to introduce an amount of pressurized fluid into the cavity 67. Each amount of fluid introduced into the cavity 67 causes a corresponding total amount of fluid to be distributed among the different channels 74 communicating with cavity 67. Each distributed amount is ejected as a drop of fluid from one of the nozzles 80.

The ejected droplets of fluid, which have approximately equal sizes, move with trajectories through the open travel space between the nozzles 80 and the substrate 120. The relative impact locations of fluid droplets striking the substrate 120 resemble the arrangement of nozzles 80 on the nozzle plate 18. The fluid droplets flow together and coalesce (i.e., merge) on the substrate 120 to define a rectilinear or trapezoidal strip of the fluid. As the fluid dispenser 10 is moved relative to the substrate 120, the fluid dispenser 10 is serially activated to dispense successive groups of fluid droplets as overlapping strips, that in the aggregate, have the appearance of a strip of dispensed fluid. The coalesced fluid droplets self-level on the substrate 120 to define a coating or film having a relatively uniform thickness.

Similar considerations apply equally to the other fluid dispensers 12, 14, which supply pressurized fluid to cavity 68 and to cavity 69, respectively. The system controller 52 causes the driver circuit 54 to energize the windings of the respective solenoid coil 40 of dispensers 12 and 14 independent of each other and also independent of the solenoid coil 40 associated with fluid dispenser 10. In this manner, each of the dispensers 10, 12, 14 can be independently controlled.

The number of nozzles 80 associated with each of the cavities 67, 68, 69 will vary depending upon the dispensing application. In one embodiment, each of the cavities 67, 68, 69 in nozzle plate 18 may include nine nozzles 80 and the second passageway 84 in each nozzle 80 may have a diameter of about 4 mils. In another embodiment, each of the cavities 67, 68, 69 in nozzle plate 18 may include eight nozzles 80 and the second passageway 84 in each nozzle 80 may have a diameter of about 5 mils.

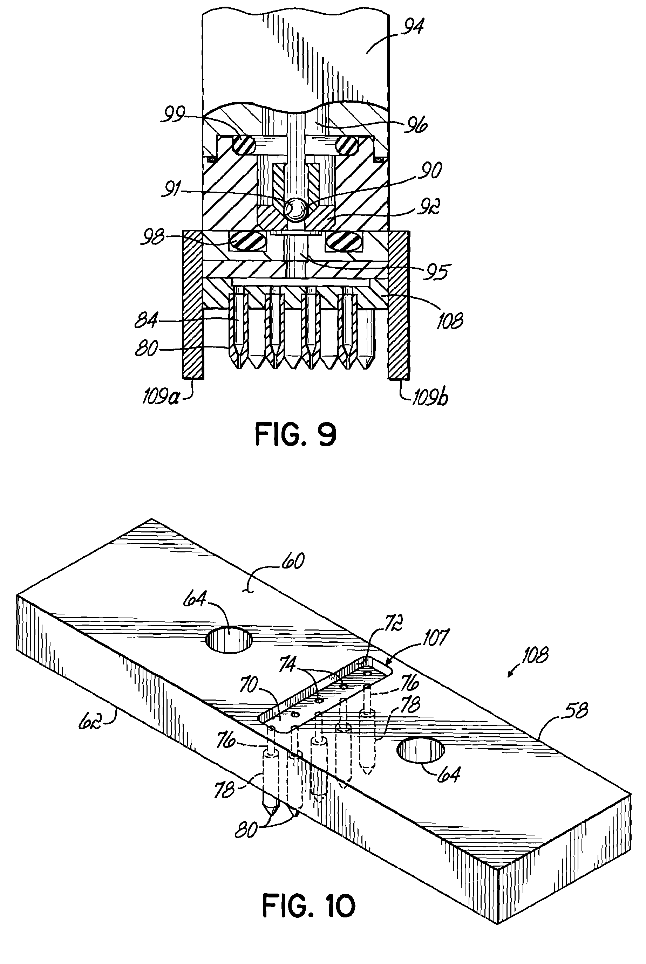

In one embodiment, a nozzle plate similar in construction to nozzle plate 108 (Fig. 10) having a single fluid cavity can be used with a single dispenser, e.g., dispenser 10, for depositing a narrow strip of fluid material on the substrate 120. This construction may be appropriate, for example, to precisely apply conformal coating material to narrow substrates 120.

The driver circuit 54 includes a power switching circuit that provides current-controlled output signals to the windings of the solenoid coil 40. The solenoid coil 40 of each of the fluid dispensers 10, 12, 14 is independently operated by the system controller 52 using, in one embodiment, pulse width modulation (PWM) of the current-controlled output signals sent from the driver circuit 54. To that end, the driver circuit 54 modulates the duty cycle of the electrical current supplied to the windings of the solenoid coil 40 of each of the fluid dispensers 10, 12, 14. The build thickness of the film deposited on the substrate 120 can be varied by changing the duty cycle of the output signals.

For each of the fluid dispensers 10, 12, 14, the driver circuit 54 and the system controller 52 are employed to precisely regulate and control the application of a pull-in current, a holding current after the pull-in current to establish an open state in which fluid is discharged, and the removal thereof from the solenoid coil 40 to establish a closed state. To that end, the driver circuit 54 applies a fast pull-in current to each solenoid coil 40 to quickly move the respective valve element 46 out of contact with the corresponding valve seat 48 at the beginning of a dispensing cycle. Additionally, the driver circuit 54 maintains a reduced holding current that holds the valve element 46 in an open position while minimizing the amount of heat build-up in the winding of the solenoid coil 40 during dispensing. Finally, the driver circuit 54 provides a rapid demagnetization of the solenoid coil 40 so that the respective valve element 46 is quickly moved into contact with its valve seat 48 to establish a closed condition at the conclusion of the dispensing cycle. Such driver circuits are disclosed, for example, in commonly-owned U.S. Patent Nos. 6,978,978, 6,318,599, 5,812,355, and 4,467,182, which are hereby incorporated by reference herein in their entirety.

The PWM of the current-controlled output signals sent from the driver circuit 54 under the control of the system controller 52 to each solenoid coil 40 causes the respective armature 26 to cyclically and repetitively move relative to the pole piece 28. This causes the respective valve element 46 to periodically reciprocate between its open and closed positions relative to the corresponding valve seat 48 and, thereby, controls the discharge or ejection of droplets from the nozzles 80 served by each of the dispensers 10, 12, 14. A group of droplets is ejected from the nozzles 80 served by each of the dispensers 10, 12, 14 each time that the corresponding valve element 46 is opened and closed. By alternating the duty cycle of the current-controlled output signals supplied to the solenoid coil 40, differing amounts of fluid can be supplied to the cavities 67, 68, 69 and subsequently discharged from the nozzles 80 as a group of droplets each having a size related to the duty cycle. The pulse width represents one factor in determining the droplet size because the amount of fluid discharged from the nozzle during one cycle of the valve element 46 depends directly on the pulse width. Other factors, such as fluid temperature, fluid pressure, etc., may also influence the droplet size.

The driver circuit 54 can vary the duty cycle of the PWM output signal from 0 percent to 100 percent. In one embodiment, the duty cycle of the PWM output signal may be less than 50 percent and, in another embodiment, the duty cycle of the PWM output signal may be about 40 percent (i.e., 40 percent on-time and 60 percent off-time). In this regard, the utilization of a duty cycle less than 50 percent may promote the straight travel paths for the discharged streams of fluid. The frequency at which pulses are supplied to the solenoid coil 40 may be on the order of up to 200 Hz to 400 Hz.

The utilization of PWM to deliver the current-controlled output signals from the driver circuit 54 to the solenoid coils 40 at a relatively high frequency and with a relatively low duty cycle promotes straight travel paths for the streams of fluid ejected from the nozzles 80. As a result, the streams of fluid are more likely to impact the substrate 120 as droplets at the intended locations, which may permit the dispense height for the nozzles 80 to be increased in comparison with conventional dispensing systems. This may be beneficial for clearing objects or components that project a relatively large height above substrate 120 when the dispensers 10, 12, 14 are moved relative to the substrate 120. For example, if the current-limited output signals duty cycles below 50 percent and at frequency of 200 Hz or greater, and said at least one fluid dispenser is suspended by said multi-axis stage such that said plurality of nozzles are located at a height of greater than 0.25 inch above the stationary substrate.

Alternatively, the solenoid coil 40 of each of the fluid dispensers 10, 12, 14 is independently operated by the system controller 52 using frequency modulation of the current-controlled output signals sent from the driver circuit 54. To that end, the driver circuit 54 modulates the frequency of the electrical current supplied to the windings of the solenoid coil 40 of each of the fluid dispensers 10, 12, 14. Frequency modulation changes the time between successive discharges of droplets from the nozzles 80, which effectively changes the spacing between the impact points of consecutive droplets ejected from the same nozzle 80 on the substrate 120 assuming that the dispensing head is moving at a constant velocity. In one embodiment of the invention, frequency modulation may be used in combination with PWM of the current-controlled output signals.

With reference to Fig. 7, a fluid dispensing system 110 includes a cabinet 112 consisting of a framework of interconnected horizontal and vertical beams partially covered by panels. Fluid dispensers 10, 12, 14 are mounted in the fluid dispensing system 110 on a multi-axis stage that includes an x-y stage positioner 116 supported by the cabinet 112 and a z-axis positioner 114, suspended from the x-y positioner 116. The x-y positioner 116 is operated by a pair of independently controllable axis drives (not shown). Similarly, the Z-axis positioner 114 is operated by another independently controllable axis drive (not shown). The z-axis positioner 114 and x-y positioner 116 provide three substantially perpendicular axes of motion for the fluid dispensers 10, 12, 14. The z-axis positioner 114 and x-y positioner 116 may in practice comprise any of a variety of conventional electromechanical and/or mechanical devices.

Substrates 120, which are intended to receive dispensed amounts of fluid, are transported to a stationary position beneath the fluid dispensers 10, 12, 14 by a conveyor 128, although other delivery mechanisms may be use. The x-y positioner 116 is capable of rapidly moving the fluid dispensers 10, 12, 14 as a group relative to the confronting surface of a substrate 120, such as a printed circuit board, in an x-y plane with high precision coordinated position control orchestrated by the system controller 52. The Z-axis positioner 114 raises and lowers the fluid dispensers 10, 12, 14 in a direction perpendicular to the x-y plane to define a three-dimensional Cartesian coordinate frame for motion. The z-axis positioner 114 is used to set a height above the substrate 120 from which to dispense fluid material such that objects projecting from the substrate 120 are not contacted as the dispensers 10, 12, 14 are moved relative to the substrate 120. Typically, the z-axis positioner 114 is used to place the fluid dispensers 10, 12, 14 at a constant height above the substrate 120 that clears the objects projecting from substrate 120. The z-axis positioner 114 and x-y positioner 116 include the electro-mechanical components, such as the motors (e.g., servos) and drive circuitry, to move the fluid dispensers 10, 12, 14. However, fluid may be dispensed while the fluid dispensers 10, 12, 14 are suspended at a single fixed height.

A motion controller 124 (FIG. 2), which is electrically coupled with the system controller 52, with the x-y positioner 116, and with the z-axis positioner 114, controls the three-dimensional movement of the fluid dispensers 10, 12, 14. The system controller 52 typically instructs the motion controller 124 to operate the x-y positioner 116 and Z-axis positioner 114 for moving the fluid dispensers 10, 12, 14 in a scripted manner that is repeated for a series of substrates 120. In one embodiment, the x-y positioner 116 is capable of moving the fluid dispensers 10, 12, 14 with a velocity of up to about 40 inches per second (about 1 meter per second).

In use, the solenoid coil 40 of each of the fluid dispensers 10, 12, 14 is independently controlled by the current-controlled output signals from the driver circuit 54 under the control of the system controller 52. Concurrently, the fluid dispensers 10, 12, 14 are moved as a group by the x-y positioner 116 at a given height above a plane containing the stationary substrate 120. This deposits a rectilinear or trapezoidal strip of fluid on the substrate 120. When objects or features are encountered on the surface of the substrate 120 and according to a programmed coating pattern, the system controller 52 can disable one or more of the fluid dispensers 10, 12, 14 by discontinuing the stream of output pulses from the driver circuit 54 and, thereby, actuate fewer than all of the fluid dispensers 10, 12, 14. Fluid is not discharged from idled fluid dispensers 10, 12, 14. As a result, the fluid dispensers 10, 12, 14 can be selectively activated so that certain objects, features, or areas on the surface of the substrate 120 are not coated by the fluid. This permits the fluid dispensers 10, 12, 14 to selectively dispense fluid in zones onto the substrate 120 without changing the direction of motion of the fluid dispensers 10, 12, 14.

For example, a component or other feature on the substrate 120 may have a width less than the corresponding extent of the nozzles 80 across the nozzle plate 18 of one of the fluid dispensers, such as fluid dispenser 12. As the fluid dispensers 10, 12, 14 are moved relative to the substrate 120, the system controller 52 instructs the driver circuit 54 to interrupt the stream of output signals to fluid dispenser 12 so that fluid dispenser 12 remains closed while the fluid dispensers 10, 12, 14 are moved over and across the feature so that the feature remains uncoated. Fluid dispensers 10 and 14 continue to dispense fluid onto the substrate 120 adjacent to the feature. Fluid dispenser 12 is closed before the feature is encountered and, after passing over the feature, is again supplied with control signals causing fluid to be discharged for coating the substrate 120.

The fluid dispensing system 110 overcomes many deficiencies of conventional coating systems that translate a substrate in a linear path relative to a stationary dispensing head with multiple nozzles. For example, such conventional coating systems must match the width of the substrate with the width of the array of nozzles. Otherwise, because the substrate is translated in the single direction and lateral movement is not permitted, the entire substrate cannot be coated. In addition, this conventional dispensing scheme lacks the ability to trace around areas on the substrate that are intended to be uncoated.

Generally, conventional dispensing schemes are limited with regard to the speed (5 inches per second or less) at which the substrate can be translated relative to the stationary dispensing head and may require nozzles with relatively large discharge passageways (0.0155 inches or larger). In contrast, the multi-axis stage of fluid dispensing system 110 can move the dispensing head relative to the substrate 120 at speeds approaching 40 inches per second (about 1 meter per second), which among other factors is possible because of the high frequency operation of the fluid dispensers 10, 12, 14. Conventional coating systems are limited in their frequency of operation, generally to a frequency less than 30 Hz, which is a limitation that may be overcome by certain embodiments of the fluid dispensing system 110. Conventional coating systems may include nozzle plates with a relatively large fluid cavity and a length of tubing coupling the fluid cavity with a dispenser, instead of directly coupling the nozzle plate 18 with dispensers 10, 12, 14 without intervening lengths of tubing and with minimization of the fluid cavity volume.

In an alternative embodiment, the fluid dispensing system 110 can include a different type of mechanism for moving the fluid dispensers relative to the substrate 120. For example, the multi-axis stage may be replaced by a programmable mechanical robot (not shown) having an articulated arm carrying the dispensing head with dispensers 10, 12, 14. The programmable mechanical robot may comprise any common configuration, including but not limited to Cartesian and SCARA (selective compliance assembly robot arm) configurations, recognized by a person having ordinary skill in the art. The programmable mechanical robot includes various motion controller and electronic system devices such as limit switches, sensors, input output terminals, amplifiers, pneumatic valves, fittings, solenoids, power supplies, programmable controllers, and servo motors and belt pulley drives for performing the required multi-axis movements of the articulated arm and dispensing head.

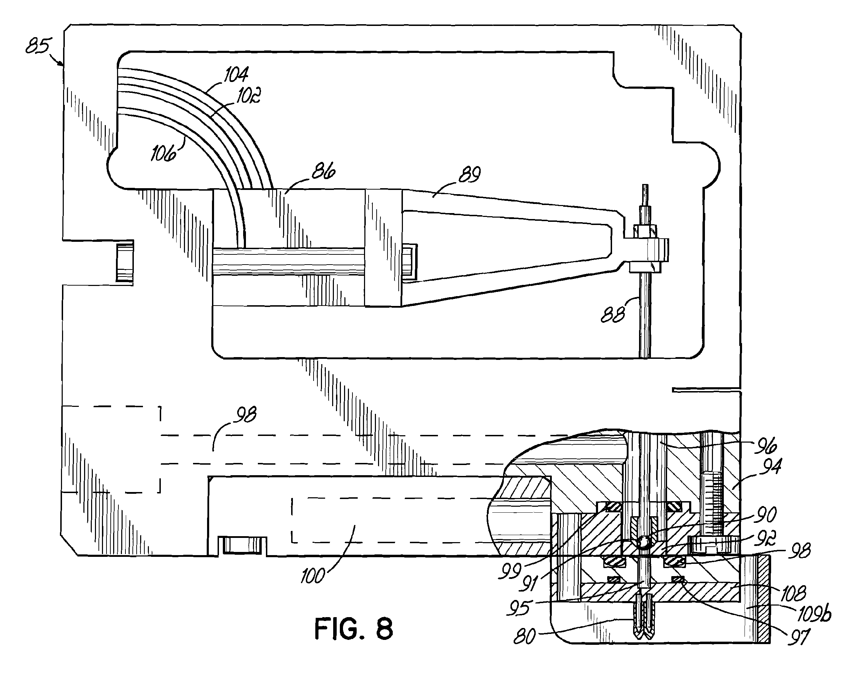

With reference to Figs. 8-10 in which like reference numeral refer to like features in Figs. 1-7 and in accordance with an alternative embodiment of the invention, a fluid dispenser 85 is shown that can be substituted for one or more of the fluid dispensers 10, 12, 14 (Figs. 1-7). The fluid dispenser 85 includes a nozzle plate 108 that is similar to nozzle plate 18 (Figs. 1-7) but, instead of an electromagnetic actuator, the fluid dispenser 85 is configured to operate using a torque motor having the form of a piezoelectric actuator 86. The piezoelectric actuator 86, which has a conventional construction, is mechanically coupled by a lever arm 89 with a shaft or valve stem 88. The valve stem 88 projects generally orthogonal relative to the lever arm 89. A valve element 90, which is situated at the free end of the valve stem 88, is moved by the operation of the piezoelectric actuator 86 relative to a valve seat 91 carried on a valve seat member 92. The valve seat member 92 and valve element 90 may be composed of a ceramic material having a composition understood by a person having ordinary skill in the art.

The valve seat member 92 is coupled to module body 94, which includes an internal cavity housing the piezoelectric actuator 86. The valve seat 91 defines a junction between a discharge passageway 95 and a fluid chamber 96, which is coupled by a fluid inlet 98 with the fluid supply 25 (Fig. 2). Fluid supplied under pressure from the fluid supply 25 is admitted through the fluid inlet 98 into the fluid chamber 96. Sealing members 97, 98, 99 supply fluid tight seals for the valve seat member 92, module body 94, and nozzle plate 108. The module body 94 includes an elongate cavity 100 that is occupied by a conventional heater (not shown), such as a cartridge-style resistance heater. The module body 94 is also equipped with a conventional temperature sensor (not shown), such as a RTD, a thermistor, or a thermocouple, providing a feedback signal for use by a temperature controller in regulating the power supplied to the heater.

The piezoelectric actuator 86 is electrically coupled by insulated wires 102, 104, 106 with the driver circuit 54, which supplies current-limited output signals to the actuator 86 with pulse width modulation, frequency modulation, or a combination thereof as described above with regard to the power supplied to solenoid coil 40. Insulated wire 102 is electrically connected with electrical ground. Insulating wire 104 is electrically connected with a top half of the piezoelectric actuator 86 and insulating wire 106 is electrically connected with a bottom half of the piezoelectric actuator 86. When power is supplied from the driver circuit 54 over insulating wire 106 to the bottom half of the piezoelectric actuator 86, an electric field is established that changes the dimensions of the actuator 86 such that the lever arm 89 is pivoted upwardly. The upward movement of the piezoelectric actuator 86, which is also mechanically amplified by the moment of the lever arm 91, lifts the valve element 90 from the valve seat 91 so that pressurized fluid can flow from the fluid chamber 96 into the discharge passageway 95. When power is supplied from the driver circuit 54 over insulating wire 104 to the top half of the piezoelectric actuator 86, an electric field is established that changes the dimensions of actuator 86 such that the lever arm 89 is pivoted downwardly. The downward movement, which is mechanically amplified by the moment of the lever arm 89, moves the valve stem 88 downwardly to contact the valve element 90 with the valve seat 91.

Other types of piezoelectric-actuated dispensers can be used in conjunction with the nozzle plate 108. For example, the piezoelectric-actuated dispenser may include a mechanical amplifier that converts the output drive force of a piezoelectric actuator into a useful displacement for the valve stem 88 that is substantially greater than the relatively small output displacement of the actuator is described in U.S. Patent No. 6,157,115, which is hereby incorporated by reference herein in its entirety.

As best shown in Fig. 10, the nozzle plate 108 includes only one fluid cavity 107, which is similar in construction and function to fluid cavities 67, 68, 69. The cavity 107 couples the discharge outlet 95 in fluid communication with the array of nozzles 80, as explained above with regard nozzle plate 18 and cavities 67, 68, 69. Attached to opposite side edges of the nozzle plate 108 are shield members 109a, 109b that protect the nozzles 80 against contact while the dispenser 85 is moved by the multi-axis stage in the x-y plane relative to the substrate 120. The nozzles 80 are located spatially between the shield members 109a, 109b. Shield members 109a, 109b project a greater distance from the nozzle plate 108 than the nozzles 80, which also prevents contact between components or objects on the substrate 120 and the nozzles 80 when the dispenser 85 is moved along the z-direction relative to the substrate 120.

The driver circuit 54 of the system controller 52 can vary the duty cycle of the PWM output signal delivered to the piezoelectric elements 86 from 0 percent to 100 percent. In one embodiment, the duty cycle of the PWM output signal may be less than 50 percent and, in another embodiment, the duty cycle of the PWM output signal may be about 25 percent (i.e., 25 percent on-time and 75 percent off time). The frequency at which pulses are supplied to the solenoid coil 40 may be on the order of 200 Hz to 400 Hz or, alternatively, up to about 1 kHz or even higher. The dispenser 85 may also be operated using frequency modulate output signals delivered from the driver circuit 54 of the system controller 52, or a combination of PWM and frequency-modulated output signals.

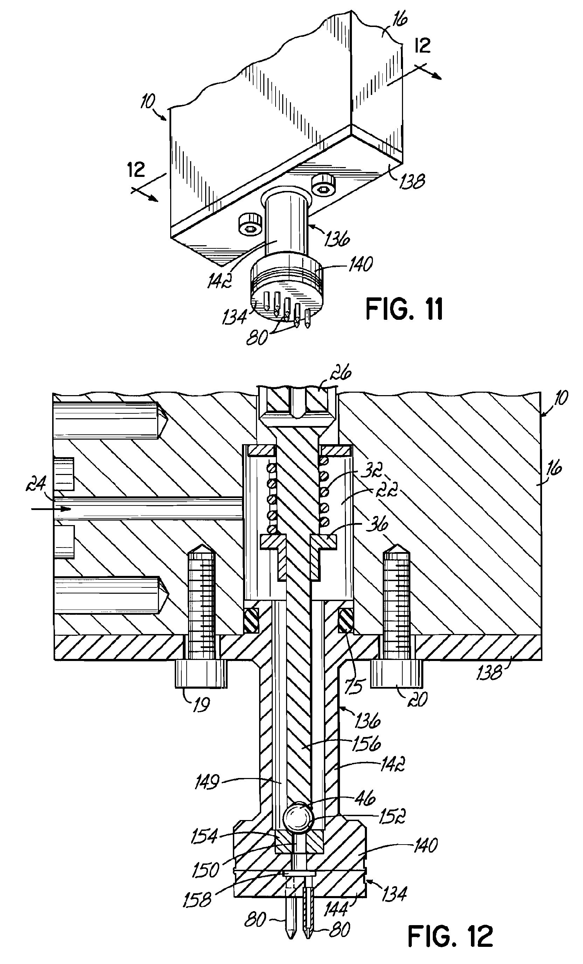

With reference to Figs. 11 and 12 in which like reference numeral refer to like features in Figs. 1-7 and in accordance with an alternative embodiment of the invention, a nozzle plate 134, which is similar to nozzle plate 18 (Figs. 1-7), is used in conjunction with an extension 136 that spaces the nozzle plate 134 from the fluid dispenser 10. The extension 136 includes a mounting plate 138 at one end that is coupled in a fluid-tight manner with the module body 16 of dispenser 10, another mounting plate 140 at an opposite end, and a stem 142 connecting the mounting plates 138, 140. Nozzle plate 134 includes a body 144, which is similar in construction and function to body 58 (Figs. 1-7), and nozzles 146 that are equivalent in construction and function to nozzles 80 (Figs. 1-7). In one embodiment, the body 144 of the nozzle plate 134 may be laser welded to the mounting plate 140 at the free end of the extension 136 that is most remote from the dispenser 10.

A central bore 149 defined centrally inside the extension 136 extends the fluid chamber 22 of the dispenser 10. The central bore 149 adjoins a discharge passageway 150 at a valve seat 152, which is carried on a valve seat member 154. A valve stem 156, which is similar to valve stem 34, projects from the armature 26 into the central bore 149. The armature 26 and valve stem 156 are moved when the windings of the solenoid coil 40 are energized and de-energized by the power supply of the system controller 52. The valve seat 152 is contacted by the valve element 46 at the free end of the valve stem 156 in the closed condition.

The discharge passageway 150 communicates with a fluid cavity 158 defined in the nozzle plate 134. The nozzles 146 discharge successive amounts of the pressurized fluid from the fluid cavity 158 when the dispenser 10 is operated. The extension 136, which has a relatively narrow profile, spaces the nozzle plate 134 from the larger profile presented by the dispenser 10. This permits the nozzle plate 134 to be located between adjacent high profile components on the substrate 120, which effectively reduces the height of the nozzles 146 above the substrate 120 when dispensing the fluid between such high profile components. This may promote more accurate dispensing of the fluid onto the substrate 120.

For purposes of this description, words of direction such as "upward", "vertical", "horizontal", "right", "left" and the like are applied in conjunction with the drawings for purposes of clarity. As is well known, liquid dispensing devices may be oriented in substantially any orientation, so these directional words should not be used to imply any particular absolute directions for an apparatus consistent with the invention.

While the present invention has been illustrated by a description of various embodiments and while these embodiments have been described in considerable detail, it is not the intention of the applicant to restrict or in any way limit the scope of the appended claims to such detail. Additional advantages and modifications will readily appear to those skilled in the art. The invention in its broader aspects is therefore not limited to the specific details, representative methods, and illustrative examples shown and described. Accordingly, departures may be made from such details without departing from the spirit or scope of applicant's general inventive concept.

## Claims

1. An apparatus for applying a pressurized fluid on a stationary substrate, the apparatus comprising:
at least one fluid dispenser including an actuator, a fluid chamber containing the pressurized fluid, a valve element coupled with said actuator, a fluid passageway, a valve seat between said fluid chamber and said fluid passageway, said actuator configured to move said valve element relative to said valve seat between an open position to permit the pressurized fluid to flow from said fluid chamber into said fluid passageway and a closed position in which said valve element contacts said valve seat to establish a fluid seal between said fluid chamber and said fluid passageway;
a multi-axis stage mechanically coupled with said at least one fluid dispenser, said multi-axis stage configured to move said at least one fluid dispenser relative to the stationary substrate; and
at least one nozzle plate mechanically coupled with a respective one of said plurality of fluid dispensers, said at least one nozzle plate including a fluid cavity coupled with said fluid passageway and a plurality of nozzles coupled with said fluid chamber, said fluid cavity configured to receive the pressurized fluid, when said valve element of said at least one fluid dispenser is in the open position, from said at least one fluid dispenser for discharge from said plurality of nozzles.

2. The apparatus of claim 1 wherein said actuator includes a valve stem carrying said valve element, at least one piezoelectric actuator, and a lever arm coupling said at least one piezoelectric actuator with said valve stem, said at least one piezoelectric actuator being selectively energized for deflecting said lever arm to move said valve stem to provide the opened and closed positions of said valve element relative to said valve seat.

3. The apparatus of claim 1 further comprising:
a driver circuit electrically coupled with said actuator, said driver circuit configured to communicate current-limited output signals to said actuator of said at least one fluid dispenser that are pulse width modulated for modulating movement of said valve element between said open and closed positions.

4. The apparatus of claim 1 further comprising:
a driver circuit electrically coupled with said actuator, said driver circuit configured to communicate current-limited output signals to said actuator of each of said fluid dispensers that are frequency modulated for modulating movement of said valve element between said open and closed positions.

5. The apparatus of claim 1 further comprising:
an extension disposed between said nozzle plate and dispenser, said extension spacing said nozzle plate from said dispenser, and said extension including a bore coupling said fluid cavity with said fluid passageway.

6. A method of dispensing a pressurized fluid onto a stationary substrate to define a coating, the method comprising:
discharging a plurality of droplets of the pressurized fluid from a plurality of nozzles onto the stationary substrate; and
moving the nozzles relative to the stationary substrate while discharging the droplets.

7. The method of claim 6 wherein discharging the droplets further comprises:
delivering a pulse width modulated output signal to an actuator of the fluid dispenser.

8. The method of claim 6 wherein discharging the droplets further comprises:
delivering a frequency modulated output signal to an actuator of the fluid dispenser.

9. The method of claim 6 further comprising:
supplying the pressurized fluid to a first fraction of the nozzles from a first fluid dispenser; and
supplying the pressurized fluid to a second fraction of the nozzles from a second fluid dispenser independent of the pressurized fluid supplied to the first plurality of nozzles.

10. The method of claim 6 further comprising:
regulating a size of the droplets such that the droplets coalesce together on the substrate to form a continuous layer defining the coating.
